# EUROPÄISCHE PATENTSCHRIFT

(11) **EP 0 812 368 B1**
(45) Veröffentlichungstag und Bekanntmachung des Hinweises auf die Patenterteilung: **02.12.1998**
(21) Anmeldenummer: 96900864.8
(22) Anmeldetag: 23.01.1996
(51) Int. Cl.: C23C 14/00, C23C 14/54

(54) **VERFAHREN ZUR REAKTIVEN BESCHICHTUNG**
REACTIVE SPUTTERING PROCESS
PROCEDE DE PULVERISATION REACTIVE

(30) Priorität: 24.02.1995 DE 19506515
(43) Veröffentlichungstag der Anmeldung: 17.12.1997
(73) Patentinhaber: FRAUNHOFER-GESELLSCHAFT ZUR FÖRDERUNG DER ANGEWANDTEN FORSCHUNG E.V., 80636 München (DE)
(72) Erfinder: FRACH, Peter, D-01324 Dresden (DE); GOTTFRIED, Christian, D-01219 Dresden (DE); WALDE, Hendrik, Fort Collins, CO 80526 (US); GOEDICKE, Klaus, D-01307 Dresden (DE)
(86) Internationale Anmeldenummer: DE9600121
(87) Internationale Veröffentlichungsnummer: WO9626302

(56) Entgegenhaltungen:
- EP-A- 0 501 016
- US-A- 5 334 302

## Beschreibung

Die Erfindung betrifft ein Verfahren zur reaktiven Beschichtung von Substraten in einer Zerstäubungseinrichtung nach dem Magnetronprinzip. Mit diesem Verfahren können z. B. Schichten mit optischen Eigenschaften oder Korrosionsschutzschichten hergestellt werden.

Beim reaktiven Beschichten wird ein elektrisch leitfähiges Target, vorzugsweise Al, Ti, In, C zerstäubt. Werden Reaktivgase wie O₂, N₂, H₂, CₓH_{y} u.a. in den Entladungsraum eingelassen, kommt es zur Bildung von Verbindungen, wie z.B. Al₂O₃, SiO_{2,} TiN.
Durch die Führung des Entladungsplasmas in einem in sich geschlossenen, aus bogenförmig gekrümmten Magnetfeldlinien gebildeten magnetischen Tunnel vor dem Target wird die Plasmadichte und die Zerstäubungsrate erhöht. Die reaktive Magnetronentladung wird u. a. vom Targetmaterial und von vom Reaktivgas abhängigen Parametern bestimmt. Diese Parameter sind die Entladungsstromstärke und die Entladungsspannung, die im wesentlichen den Arbeitspunkt des Verfahrens festlegen. Durch die Reaktivgaskomponente weist die Magnetronentladung einen zusätzlichen Freiheitsgrad auf. Bei sehr vielen Target-Reaktivgaskombinationen treten zumindest in Teilen des Arbeitsbereiches Instabilitäten auf. Die Entladung bewegt sich in einen vollständig anderen Arbeitspunkt, der andere Parameter und somit andere Schichteigenschaften zur Folge hat.

Es ist bekannt, zur Stabilisierung der reaktiven Magnetronentladung die Partialdrücke des Edelgases und Reaktivgases derart zu wählen, daß der Entladungsstrom oder die Entladungsspannung bei Änderung des Reaktivgaspartialdruckes konstant bleibt und die Abhängigkeit des Entladungsstromes oder der Entladungsspannung vom Reaktivgaspartialdruck zur Regelung des Reaktivgases verwendet wird (DD 146 306). Weiterhin ist ein analoges Regelverfahren bekannt, womit der Arbeitspunkt beim zugehörigen Reaktivgasfluß durch Dosierung des eingeleiteten Reaktivgases eingestellt und konstant gehalten wird (DE 41 06 513 A 1). Diese Verfahren haben den Nachteil, daß sie sich nur zur relativ kurzzeitigen Stabilisierung für einen Bruchteil der Targetstandzeit eignen, da im Laufe der Gebrauchsdauer des Targets sich mit steigender Erosionstiefe die wirksame Magnetfeldstärke und damit die Entladungsparameter und die Reaktionskinetik ändern, was zur Änderung der Eigenschaften der abgeschiedenen Schichten führt. Aus diesem Grund muß eine ständige Nachführung des Arbeitspunktes anhand gemessener Schichteigenschaften erfolgen. Desweiteren eignen sich diese Verfahren nur für Magnetronzerstäubungsquellen mit nur einem Entladungsplasma.

Weiterhin kommt es durch die fokussierende Wirkung des Erosionsgrabens zur Ausbildung einer sich verbreiternden Rückstäubzone an den Targeträndern. Insbesondere bei isolierenden Schichten wie Al₂O₃ oder SiO₂ führen diese Rückstäubzonen zu Bogenentladungen und damit zu störenden Partikeln in der abgeschiedenen Schicht. Ein weiterer entscheidender Nachteil der gegenwärtig bekannten technischen Lösungen ist, daß sie es nicht erlauben mit mehreren Teiltargets gleicher oder unterschiedlicher Teilleistung einen reaktiven Zerstäubungsprozeß langzeitstabil und reproduzierbar über eine Targetstandzeit zu realisieren.

Desweiteren ist bekannt, zur Schichtabscheidung auf Substraten mit einem Durchmesser größer 100 mm - mit einer sehr guten Homogenität von Schichtdicke und Schichteigenschaften - das Target in Teiltargets aufzuteilen. Bei einer solchen Magnetronzerstäubungsquelle - auch Zweiringquelle genannt - sind zwei Teiltargets konzentrisch angeordnet, wobei vor jedem Teiltarget ein Entladungsplasma brennt (DE 41 27 262 C 1). Die Leistungsdichten und damit die Targeterosion auf den konzentrischen Teiltargets unterscheiden sich je nach Beschichtungsgeometrie um den Faktor 2 bis 5 voneinander. Die Änderung der Plasmaparameter mit zunehmender Targeterosion ist deshalb sehr unterschiedlich. Bei nichtreaktiver Betriebsweise ist die Einstellung der Schichtdickengleichmäßigkeit durch Wahl der Teilentladungsleistungen möglich und ausreichend. Ein großer Nachteil der reaktiven Betriebsweise einer derartigen Magnetronzerstäubungsquelle sind die außerordentlich hohen Anforderungen, die an das Verfahren gestellt werden, um u.a. die Stöchiometriehomogenität langzeitstabil und reproduzierbar zu erzielen. Die Gründe dafür sind, daß die Stabilität der Entladung, ihr Arbeitspunkt und damit die Stöchiometrie entscheidend vom Verhältnis Leistungsdichte zum Reaktivgasangebot bestimmt wird. Außerdem hängen einige Schichteigenschaften (z. B. die Härte) und die Beschichtungsrate außer von der Stöchiometrie auch von den eingestellten Werten der Entladungsspannung und/oder des Entladungsstromes ab [P. Frach et all, *Surface and Coating Technology,* 59(1993)177]. Stabilisiert man nur die Teilentladungsleistung, führt dies letztlich zu einer Drift der Schichteigenschaften und deren Homogenität. So führt z. B. eine kurzeitige lokale Schwankung des Sauerstoffflusses beim reaktiven Abscheiden von Al₂O₃ vom Al-Target zum Verschieben des Arbeitspunktes der Entladung des jeweiligen Teiltargets und damit zu Eigenschaftsveränderungen.

Es ist weiterhin bekannt, reaktive Magnetronzerstäubung derart durchzuführen, daß an zwei Targets unterschiedlichen Materials eine Impulsspannung (Wechselspannung) angelegt wird. Mittels Sensoren werden Prozeßparameter von Entladungsstrom und -spannung und der Gasdruck gemessen und mit einem Sollwert verglichen. Um gleiche Zerstäubungsgeschwindigkeit beider Targets zu erzielen, werden die erhaltenen Signale in einem Steuerprogramm verarbeitet, um qualitativ gute Schichteigenschaften auf dem Substrat zu erhalten (DE 43 24 683). Das Verfahren hat aber den Mangel, daß es nicht oder nur schwer möglich ist, die Entladungsleistung oder Leistungsdichte der einzelnen Targets, bzw. Teiltargets, unabhängig voneinander zu regeln. Der Grund dafür ist, daß die erforderlichen Parameter zum Vergleich mit dem Sollwert nicht für jedes Target bzw. Teiltarget erfaßbar sind.

Der Erfindung liegt die Aufgabe zugrunde, die Eigenschaften der abgeschiedenen Schicht, wie chemische Zusammensetzung, physikalische Eigenschaften, sowohl während der Beschichtung eines Substrates als auch über die gesamte Gebrauchsdauer eines Targets unabhängig vom Erosionszustand konstant zu halten. Auch nach einem Targetwechsel soll keine erneute Justage des Prozesses, d. h. Einstellung und ständige Korrektur des Arbeitspunktes entsprechend der erreichten Schichteigenschaften, erforderlich sein. Die Bestimmung charakteristischer Schichteigenschaften soll nur noch der abschließenden Qualitätskontrolle dienen. Mit dem Verfahren sollen die Rückstäubzonen vermieden bzw. ihre Verbreiterung verhindert werden. Das Verfahren soll für verschiedene Typen von Magnetronzerstäubungsquellen mit einem oder aus mehreren Teilen bestehenden Targets geeignet sein. Das Verfahren soll auch bei unterschiedlicher Teilentladungsleistung oder Leistungsdichte für die Teiltargets anwendbar sein. Das Verfahren soll es auch ermöglichen, elektrisch schlecht leitende oder isolierende Verbindungen wie Al₂O₃, SiO₂ kurzzeitig mit gleichbleibenden Eigenschaften und geringer Partikeldichte der abgeschiedenen Schicht herzustellen.

Erfindungsemäß wird die Aufgabe nach den Merkmalen des Anspruches 1 gelöst. Weitere Ausgestaltungen sind in den Ansprüchen 2 bis 21 beschrieben

Die Anwendung des erfindungsgemäßen Verfahrens zeigt, daß sich das für die reaktive Schichtbildung notwendige Verhältnis der Plasmaparameter zum Reaktivgas ausschließlich mit elektrischen Meßwerten erfassen und charakterisieren läßt, und mittels Regelkreisen über die Stellung geeigneter Einflußgrößen - wie Magnetfeld, Einspeisungszeit der Leistungseinspeisung und Reaktivgasfluß - der Abscheidungsprozeß langzeitstabil und reproduzierbar gestaltbar ist. Desweiteren ist es möglich, für die Plasmaentladung charakteristische Meßgrößen auch optisch und/oder elektrisch zu erfassen. Es ist vorteilhaft, das Verhältnis der optischen Intensitäten zweier charakteristischer Spektrallinien der Plasmaentladung als optische Meßgröße zu verwenden. Mit diesem Verfahren ist es möglich, den reaktiven Abscheideprozeß über die Standzeit eines Targets und von Target zu Target mit gleichbleibenden Schichteigenschaften durchzuführen. Eine ständige Kontrolle der Schichteigenschaften und Nachjustierung der Prozeßparameter entsprechend dieser Kontrollergebnisse ist damit für eine langzeitige Prozeßführung nicht notwendig. Dadurch wird die Ausschußquote für die beschichteten Substrate erheblich reduziert und eine Automatisierung führt zu höherer Produktivität und Kostensenkung.
Durch die Einstellung der individuellen Magnetfeldstärke und/oder der individuellen Leistungseinspeisungszeit für jedes Teiltarget ist es möglich, die Plasmaparameter ohne Reaktivgaseinfluß über die Targeterosionsdauer konstant zu halten. Als Maß für die Einstellung dient ein individuelles Wertepaar, z. B. von Entladungsspannung und Entladungsstrom, bei einer über die Periodendauer gemittelten individuellen Leistung. Diese elektrischen Kenngrößen können über die Targeterosion konstant gehalten werden oder auch nach einem einmalig zuvor durchgeführten Einstellvorgang, z. B. für ein Al-Target, in Abhängigkeit von der Targeterosion ermittelt und dann als Vorgabewerte für weitere, aus gleichem Material bestehende Targets verwendet werden. Eine weitere positive Wirkung ist, daß die Targeterosion gleichmäßiger erfolgt und die progressive Entwicklung von Rückstäubzonen dauerhaft vermieden bzw. stark reduziert wird. Damit wird die Neigung zu Bogenentladungen und die Entstehung von Partikeln in der abgeschiedenen Schicht vermieden bzw. drastisch vermindert.
Während der reaktiven Beschichtung erfolgt keine Veränderung der Magnetfeldstärke. Als Maß für die Einstellung des Arbeitspunktes der reaktiven Entladung dient ein individuelles Wertepaar, z. B. von Entladungsspannung und Entladungsstrom, bei einer über die Periodendauer gemittelten individuellen Leistung. Diese elektrischen Kenngrößen können über die Targeterosion konstant gehalten werden, oder auch nach einem zuvor durchgeführten Einstellvorgang in Abhängigkeit von der Targeterosion ermittelt und dann als Vorgabewerte für weitere Targets aus gleichem Material verwendet werden.
Soll die Beschichtung bei unveränderlicher Leistungseinspeisungszeit erfolgen, wird die Einstellung und Stabilisierung des Arbeitspunktes der reaktiven Entladung durch Stellung des Reaktivgasflusses mittels einer Reaktivgasregelschleife vorgenommen.
Bei der Durchführung des Verfahrens mit einem gemeinsamen Reaktivgaseinlaß für mehrere Teiltargets kann zu dessen Regelung in vorteilhafter Weise der Wertesatz von für die reaktive Entladung charakteristischen Meßgrößen eines ausgewählten Teiltargets, z. B. desjenigen mit der größten Teilentladungsleistung, verwendet werden. Für weitere Teiltargets wird die Einstellung und Stabilisierung des Arbeitspunktes der reaktiven Entladung durch Stellung der individuellen Leistungseinspeisungszeit mittels einer Regelschleife vorgenommen. Dieses Verfahren ist aber ebensogut für Magnetronzerstäubungsquellen mit nur aus einem Teil bestehenden Targets geeignet.

Das Magnetfeld läßt sich sowohl mittels Permanentmagneten als auch mittels Elektromagneten oder einer Kombination von beiden erzeugen. Die Veränderung der Magnetfeldstärke kann z. B. entweder durch mechanische Verstellung des Abstandes eines Permanentmagnetsystems von der Targetoberfläche und/oder durch Änderung des Spulenstromes eines Elektromagneten erfolgen.
Die Periodendauer der intermittierenden Leistungseinspeisung in das Plasma kann vorteilhafterweise im Bereich einiger Mikrosekunden bis einiger Sekunden erfolgen. Insbesondere bei Periodendauern im Bereich von 5 Mikrosekunden bis 50 Mikrosekunden ergibt sich eine Betriebsweise mit besonders wenigen Bogenentladungen.
Eine zusätzliche Reduktion der Neigung zu Bogenentladungen läßt sich durch eine niederohmige leitende Verbindung zwischen Teiltarget und Anodenpotential erreichen, wobei die Spannung zwischen Teiltarget und Anode kleiner als 15 V betragen sollte. Der Einsatz einer Bogenerkennungsschaltung in der Leitung zwischen Teiltarget und Anode der Entladung zur vorzeitigen Abschaltung der Leistungseinspeisung und anschließenden niederohmigen leitenden Verbindung führt zu einer Verringerung der Energieeinspeisung in den Bogen, so daß ein Partikeleinbau in die abgeschiedene Schicht ausgeschlossen oder stark vermindert wird.

Zur Durchführung des Verfahrens ist es vorteilhaft, die Leistungseinspeisung derart vorzunehmen, daß die Teiltargets während der Einspeisungszeit stets Katoden der Entladung sind. Die Entladung erfolgt gegen eine als Anode geschaltete weitere Elektrode, die gegen die Vakuumkammer elektrisch isoliert, elektrisch leitend mit ihr verbunden oder ein Bestandteil der Vakuumkammer sein kann.

Eine weitere vorteilhafte Ausgestaltung des Verfahrens besteht darin, daß bei der Verwendung von zwei Teiltargets ein Teiltarget Katode und das zweite Teiltarget Anode der Entladung ist. In der darauffolgenden Periodendauer ist das jeweils andere Target Katode bzw. Anode der Entladung. Der Wechsel der Polung der Teiltargets soll derart erfolgen, daß regelmäßig periodisch jedes Teiltarget einmal Anodenfunktion hat, um damit in bestimmten Abständen die Reinigung des Teiltargets zu erreichen. Die während der Einspeisungszeiten eingespeisten Leistungen sind für beide Polungsrichtungen unabhängig voneinander wählbar. Wahlweise kann mindestens eine Zusatzelektrode während aller Periodendauern auf ein wahlfreies elektrisches Potential eingestellt werden. Dieses wahlfreie Potential kann z. B. Anodenpotential sein, was sich günstig auf das Zündverhalten auswirkt. In bestimmten Fällen ist es jedoch sinnvoll, mindestens eine Zusatzelektrode elektrisch floatend anzuordnen. Dies hat stabilisierenden Einfluß auf die Entladung und reduziert die Neigung zu Bogenenentladungen.

Eine weitere vorteilhafte Ausgestaltung des Verfahrens besteht darin, daß die Zündung der reaktiven Entladung im Edelgas-Reaktivgas-Gemisch mit einem vorgegebenen Wert des Reaktivgasflusses oder Reaktivgaspartialdruckes erfolgt und anschließend durch die Reaktivgas-Regelschleife selbsttätig der Arbeitspunkt der Entladung eingestellt wird. Dadurch lassen sich Zwischenschichten mit unerwünschten Zusammensetzungen vermeiden, wie sie z. B. bei Zündung der Entladung im Edelgas auftreten. Bei einigen Kombinationen von Targetmaterial und Reaktivgas zündet die Entladung im Edelgas-Reaktivgas-Gemisch und bei niedrigeren Entladungsspannungen bzw. Gesamtdrücken wesentlich besser. Außerdem läßt sich dadurch eine Beschichtung ohne Bewegung einer Blende zwischen der Magnetronzerstäubungsquelle und dem Substrat erreichen. Diese Blende ist erforderlich, wenn die Entladung im reinen Edelgas gezündet wird, weil dadurch bis zum Erreichen des Arbeitspuktes eine nichtreaktive Zwischenschicht entstehen würde. Andererseits hat diese Ausgestaltung der Erfindung den Vorteil, daß nicht die Gefahr einer zu starken Bedeckung des Targets mit Reaktionsprodukten entsteht, da bei einigen Reaktivprozessen das Einstellen des Arbeitspunktes mit bedecktem Target erst nach unvorteilhaft langer Zerstäubungszeit möglich ist.

An zwei Ausführungsbeispielen wird die Erfindung näher erläutert. In den zugehörigen Zeichnungen zeigen:
- Fig. 1:: einen Halbschnitt durch eine Magnetronzerstäubungsquelle im unipolaren Betrieb,
- Fig. 2:: einen Halbschnitt durch eine Magnetronzerstäubungsquelle im bipolaren Betrieb.

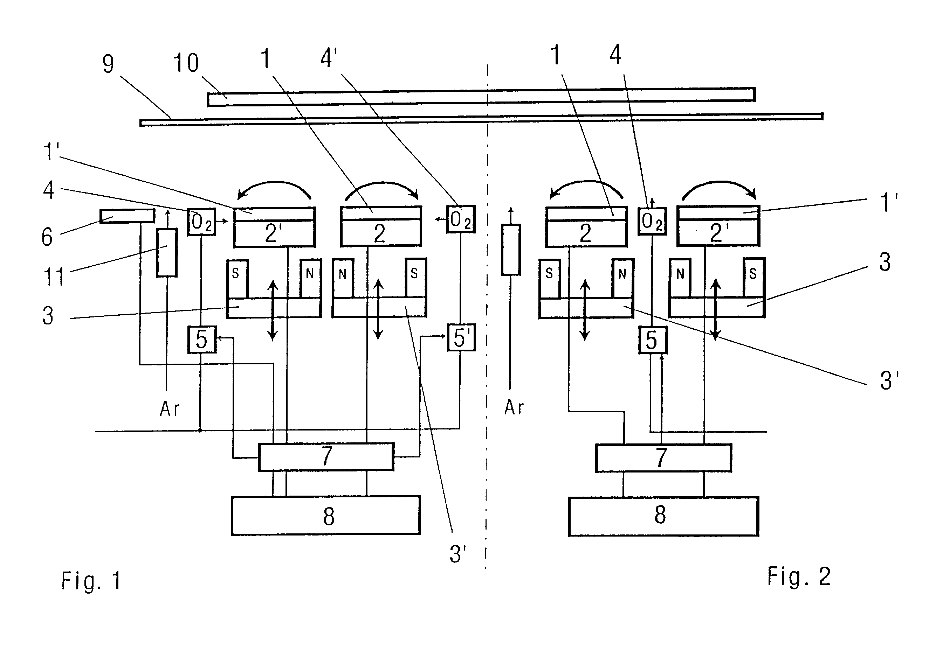

Die Magnetronzerstäubungsquelle gemäß Fig. 1 besteht aus den Teiltargets 1, 1', die auf Kühlplatten 2, 2' befestigt sind. Die hinter den Teiltargets 1, 1' angeordneten Magnete 3, 3' des Magnetsystems lassen sich in bekannter Weise in Richtung der Teiltargets 1, 1' mechanisch verstellen. Neben den Teiltargets 1, 1' ist je ein Reaktivgaseinlaß 4, 4' angeordnet. Mit 5 und 5' sind die Regelventile für den Reaktivgaseinlaß 4 und 4' bezeichnet. Desweiteren gehören zu dieser Magnetronzerstäubungsquelle eine Zusatzelektrode 6, eine Meßwerterfassungs- und Regeleinheit 7 und eine Leistungseinspeisungseinheit 8. Die Leistungseinspeisungseinheit 8 hat die Aufgabe, eine pulsförmige Leistung für die Teiltargets 1, 1' bereitzustellen. Über den Teiltargets 1, 1' ist hinter einer Schwenkblende 9 ein Substrat 10 angeordnet. Mit 11 ist ein Edelgaseinlaß bezeichnet, der in Targetnähe angeordnet ist.

Das Verfahren wird erfindungsgemäß wie folgt ausgeübt: In einem ersten Schritt wird vor dem reaktiven Beschichten der Substrate 10 die jedem Teiltarget 1, 1' zugeordnete Magnetfeldstärke im Edelgas (Argon) ohne Reaktivgaszuführung eingestellt. Zu diesem Zweck wird über einen Edelgaseinlaß 11 Argon eingelassen. Die Regelventile 5, 5' sind bei diesem Verfahrensschritt geschlossen. Bei einer vorgegebenen Leistung für jedes Teiltarget 1, 1' brennt die Entladung zwischen jedem Teiltarget 1, 1' und der als Anode geschalteten Zusatzelektrode 6. Dabei stellt sich für jedes Teiltarget 1, 1' ein bestimmter Entladungsstrom und eine bestimmte Entladungsspannung ein. Durch ein Verschieben der den Teiltargets 1, 1' zugeordneten Magnete 3, 3' ändert sich die Magnetfeldstärke jedes Teiltargets 1, 1'. Dieser Vorgang wird solange durchgeführt, bis sich an jedem Teiltarget 1, 1' die vorgegebenen charakteristischen Meßgrößen (Entladungs-spannung und Entladungsstrom) einstellen. Die Schwenkblende 9 schirmt bei diesem Schritt das Substrat 10 von den Teiltargets 1, 1' ab. In einem nächsten Schritt wird die Magnetfeldstärke konstant gehalten, d. h. die Magnete 3, 3' werden nicht bewegt. Am Edelgaseinlaß 11 wird ein konstanter Argonfluß eingestellt. An der Leistungseinspeisungseinheit 8 wird eine vorgegebene Entladungsspannung eingestellt und konstant gehalten. Über den Reaktivgaseinlaß 4, 4' wird Sauerstoff eingelassen, so daß nunmehr die Entladung in einer reaktiven Atmosphäre brennt. Dabei stellt sich für jedes Teiltarget 1, 1' ein bestimmter Entladungsstrom und damit eine bestimmte Entladungsleistung ein. Der jeweilige Entladungsstrom wird in bekannter Weise von der Meßwerterfassungsund Regeleinheit 7 erfaßt und ein Signal derart an das entsprechende Regelventil 5, 5' gegeben, daß dadurch der Sauerstofffluß so verändert wird, bis die jeweilige Entladungsleistung mit der für jedes Teiltarget 1, 1' vorgegebenen Leistung übereinstimmt. Während dieses Schrittes bleibt die Schwenkblende 9 geschlossen.

Im nächsten Schritt erfolgt die Beschichtung des Substrats 10. Dazu erfolgt die pulsförmige Leistungseinspeisung durch die Leistungseinspeisungseinheit 8, so daß die Entladung in einer Argon-Sauerstoff-Atmosphäre zwischen jedem Teiltarget 1, 1' und der Zusatzelektrode 6 brennt. Dabei wird der jeweilige Entladungs-strom der Teiltargets 1, 1' von der Meßwerterfassungs- und Regeleinheit 7 erfaßt und mit Hilfe der Regelventile 5, 5' wird der Sauerstofffluß so geregelt, daß die Entladungsleistung jedes Teiltargets 1, 1' mit der für jedes Teiltarget 1, 1' vorgegebenen Leistung übereinstimmt. Bei geöffneter Schwenkblende 9 erfolgt nun die Beschichtung des Substrats 10.
Um gleichbleibende Entladungsbedingungen und damit gleichbleibende Schichteigenschaften zu gewährleisten, werden nach einer bestimmten Anzahl von Beschichtungen die ersten zwei Schritte der Magnetfeldeinstellung für jedes Teiltarget 1, 1' und die Regelung des Sauerstoffflusses für jedes Teiltarget 1, 1' zur Angleichung der Entladungsleistung an eine vorgegebene Leistung (ohne Substrat) wiederholt. Anschließend wird die Beschichtung der Substrate 10 fortgesetzt.

In Fig. 2 ist ebenfalls eine Magnetronzerstäubungsquelle dargestellt, mit dem Unterschied, daß nur ein Reaktivgaseinlaß 4 zwischen den Teiltargets 1, 1' angeordnet ist. Die Zusatzelektrode 6 entfällt, da diese Magnetronzerstäubungseinrichtung bipolar betrieben wird, d. h. die Teiltargets 1, 1' werden abwechselnd als Katode bzw. Anode der Entladung geschaltet.

Die ersten beiden Schritte des Verfahrens, die Einstellung der Magnetfeldstärke und des Arbeitspunktes, erfolgen wie im Zusammenhang mit Fig. 1 beschrieben. Da aber nur ein Reaktivgaseinlaß 4 vorhanden ist und die Entladungen bedingt durch die unterschiedliche Geometrie unterschiedliche Entladungsparameter besitzen, wird erst das Teiltarget 1 durch die Regelung des Sauerstoffflusses an eine vorgegebene Leistung angeglichen. Das zweite Teiltarget 1' besitzt dadurch Entladungsparameter, die von einer vorgegebenen Leistung abweichen. Um die Entladungsleistung des zweiten Teiltargets 1' an die vorgegebene Leistung anzugleichen, wird die Einspeisungszeit der Leistungseinspeisung derart verändert, bis die gemessene Leistung mit der vorgegebenen Leistung für dieses Teiltarget 1 ' übereinstimmt.

## Patentansprüche

1. Verfahren zur reaktiven Beschichtung von Substraten mittels einer Zerstäubungsquelle nach dem Magnetronprinzip, bestehend aus einem aus mindestens einem Teil bestehenden Target, einem hinter dem Target diesem angepaßten Magnetsystem und mindestens einem regelbaren Gaseinlaß, mit pulsförmiger Leistungseinspeisung in das Plasma bei einer Periodendauer, die sich aus Einspeisungszeit und Pausendauer zusammensetzt, **gekennzeichnet durch** folgende Verfahrensschritte:
a. vor dem Beschichten der Substrate wird die jedem Teiltarget zugeordnete Magnetfeldstärke und/oder Einspeisungszeit der pulsförmigen Leistungseinspeisung im Edelgas ohne Reaktivgas bei einem Entladungsdruck so lange verändert, bis ein für jedes Teiltarget vorgegebener Wertesatz von für die nichtreaktive Plasmaentladung charaktristischen Meßgrößen erreicht wird,
b. vor dem Beschichten der Substrate werden die Entladungsparameter bei Konstanthalten der eingestellten Werte der Magnetfeldstärke durch Einlaß von Reaktivgas oder eines Gemisches aus Reaktivgas und Edelgas und/oder der Einspeisungsdauer der pulsförmigen Leistungseinspeisung so lange verändert, bis ein für jedes Teiltarget vorgegebener Wertesatz von für die reaktive Entladung charakteristischen Meßgrößen erreicht wird,
c. während der nun folgenden Beschichtung der Substrate wird durch Regelung des Gasflusses oder des Gasdruckes mittels des regelbaren
Gaseinlasses und/oder der Einspeisungsdauer der pulsförmigen Leistungseinspeisung der für jedes Teiltarget zumindest für einen bestimmten Bruchteil der Gebrauchsdauer des Teiltargets fest vorgegebene Wertesatz von für die reaktive Entladung charakteristischen Meßgrößen konstant gehalten,
d. in bestimmten Zeitabständen während der Gebrauchsdauer der Teiltargets werden die Verfahrensschritte a und b wiederholt, ehe die Beschichtung der Substrate fortgesetzt wird.

2. Verfahren nach Anspruch 1, **dadurch gekennzeichnet**, daß der Wertesatz für die Plasmaentladung charakteristischer Meßgrößen aus einem Wertetripel von Entladungs-spannung, Entladungsstrom und in das Plasma eingespeister, über die Periodendauer ermittelter Leistung gebildet wird.

3. Verfahren nach Anspruch 1, **dadurch gekennzeichnet**, daß der Wertesatz für die Plasmaentladung charakteristischer Meßgrößen aus einem Wertepaar von Entladungs-spannung und einem optisch oder elektrisch gewonnenen, den Plasmazustand kennzeichnendes Signal gebildet wird.

4. Verfahren nach Anspruch 1, **dadurch gekennzeichnet**, daß der Wertesatz für die Plasmaentladung charakteristischer Meßgrößen aus einem Wertepaar von Entladungsleistung und einem optisch oder elektrisch gewonnenen, den Plasmazustand kennzeichnendes Signal gebildet wird.

5. Verfahren nach Anspruch 1, **dadurch gekennzeichnet**, daß der Wertesatz für die Plasmaentladung charakteristischer Meßgrößen aus einem Wertepaar von Entladungsstrom und einem optisch oder elektrisch gewonnenen, den Plasmazustand kennzeichnendes Signal gebildet wird.

6. Verfahren nach Anspruch 1 und einem der Ansprüche 2 bis 5, **dadurch gekennzeichnet**, daß der Wertesatz für die Plasmaentladung charakteristischer Meßgrößen in Abhängigkeit vom Erosionszustand über die Gebrauchsdauer der Teiltargets vorgegeben wird.

7. Verfahren nach Anspruch 6, **dadurch gekennzeichnet**, daß die gebildeten Wertesätze für die einzelnen Verfahrensschritte gleich oder unterschiedlich sind.

8. Verfahren nach mindestens einem der Ansprüche 1 bis 7, **dadurch gekennzeichnet**, daß die Periodendauer im Bereich von einigen Mikrosekunden bis einige Sekunden eingestellt wird.

9. Verfahren nach mindestens einem der Ansprüch 1 bis 8, , **dadurch gekennzeichnet**, daß die Leistung derart eingespeist wird, daß die Teiltargets während der Einspeisungszeit stets Katoden der Entladung sind und die Entladung gegen mindestens eine im Entladungsraum befindliche Zusatzelektrode brennt, die als Anode geschaltet wird.

10. Verfahren nach mindestens einem der Ansprüche 1 bis 9, **dadurch gekennzeichnet,** daß die Leistung derart eingespeist wird, daß bei mehreren Teiltargets in einer Periodendauer während der Einspeisungszeit ein Teil der Teiltargets als Katode und jeweils mindestens ein Teiltarget als Anode geschaltet werden, daß während der darauf folgenden Periodendauer während der Einspeisungszeit jeweils mindestens ein bisher als Katode geschaltetes Teiltarget als Anode und umgekehrt geschaltet werden, daß jedes Teiltarget regelmäßig periodisch Anodenfunktion hat und daß für beide Polungsrichtungen die Einspeisungszeiten und die dabei eingespeisten Leistungen unabhängig voneinander gewählt werden.

11. Verfahren nach Anspruch 10, **dadurch gekennzeichnet**, daß mindestens eine Zusatzelektrode während der Periodendauern als Anode geschaltet wird.

12. Verfahren nach Anspruch 10, **dadurch gekennzeichnet**, daß mindestens eine Zusatzelektrode während der Periodendauern auf ein wahlfreies elektrisches Potential eingestellt wird.

13. Verfahren nach Anspruch 9 bis 12, **dadurch gekennzeichnet**, daß die Leistungseinspeisung derart erfolgt, daß die Teiltargets während der Pausendauer derartig niederohmig mit Anodenpotential verbunden werden, daß dabei die Spannung zwischen dem Teiltarget und der Anode von 15 V nicht überschritten wird.

14. Verfahren nach mindestens einem der Ansprüche 1 bis 13, **dadurch gekennzeichnet**, daß der zur Regelung benutzte Istwert der einzuspeisenden Leistung aus der zeitgenauen Multiplikation von Entladungsspannung und Entladungsstrom durch Mittelwertbildung über eine Periodendauer ermittelt wird.

15. Verfahren nach mindestens einem der Ansprüche 1 bis 14, **dadurch gekennzeichnet**, daß das Reaktivgas oder Reaktivgasgemisch in den Entladungsraum in der Nähe des Targets bzw. Teiltargets zugeführt wird.

16. Verfahren nach mindestens einem der Ansprüche 1 bis 15, **dadurch gekennzeichnet**, daß die Entladung im Edelgas ohne Zuführung von Reaktivgas gezündet wird und anschließend mittels einer Reaktivgas-Regelschleife selbsttätig der Arbeitspunkt der Entladung eingestellt wird.

17. Verfahren nach mindestens einem der Ansprüche 1 bis 15, **dadurch gekennzeichnet**, daß mit einem vorgegebenen Wert des Reaktivgasflusses oder Reaktivgases die reaktive Entladung im Edelgas-Reaktivgas-Gemisch gezündet wird und anschließend mittels einer Reaktivgas-Regelschleife selbsttätig der Arbeitspunkt der Entladung eingestellt wird.

18. Verfahren nach mindestens einem der Ansprüche 1 bis 17, **dadurch gekennzeichnet**, daß die Leistung während der reaktiven Beschichtung nach einer Leistungs-Konstanz-Verfahrensweise eingespeist wird und mittels der Reaktivgas-Regelschleife der Reaktivgasfluß derart eingestellt wird, daß die Entladungsspannung oder der Entladungsstrom auf einen vorgegebenen Wert stabilisiert werden.

19. Verfahren nach mindestens einem der Ansprüche 1 bis 17, **dadurch gekennzeichnet**, daß die Leistung während der reaktiven Beschichtung nach einer Spannungs-Konstanz-Verfahrensweise eingespeist wird und mittels der Reaktivgas-Regelschleife der Reaktivgasfluß derart eingestellt wird, daß die Entladungsleistung oder der Entladungsstrom auf einen vorgegebenen Wert stabilisiert werden.

20. Verfahren nach mindestens einem der Ansprüche 1 bis 17, **dadurch gekennzeichnet**, daß die Leistung während der reaktiven Beschichtung nach einer Strom-Konstanz-Verfahrensweise eingespeist wird und mittels der Reaktivgas-Regelschleife der Reaktivgasfluß derart eingestellt wird, daß die Entladungsspannung oder die Entladungsleistung auf einen vorgegebenen Wert stabilisiert werden.

21. Verfahren nach Anspruch 1 bis 17, **dadurch gekennzeichnet**, daß mittels mehrerer Regelschleifen für einen Teil der Teiltargets der Reaktivgasfluß und für den anderen Teil der Teiltargets die Einspeisungszeit der pulsförmigen Leistungseinspeisung der für jedes Teiltarget vorgegebene Wertesatz von für die reaktive Entladung charakteristischen Meßgrößen konstant gehalten wird.

## Claims

1. A method of reactive coating of substrates by means of a dissociating source on the magnetron principle, consisting of a target consisting of at least one part, a magnet system behind the target and matched thereto and at least one regulated gas inlet, with pulsed power input to the plasma with a period made up of a supply time and a pause duration, characterized by the following method steps:
a. before coating the substrate the magnet field strength associated with each sub-target and/or the supply time of the pulsed power input in the inert gas without reactive gas is varied at a discharge pressure until a predetermined set of values of measured variables characteristic of the non-reactive plasma discharge is attained for each sub-target,
b. before coating the substrate the discharge parameters are vaned while keeping the set values of the magnetic field strength constant by inlet of reactive gas or a mixture of reactive gas and inert gas and/or the supply duration of the pulsed power supply is varied until a predetermined set of values of measured variables characteristic of the reactive discharge is attained for each sub-target,
c. during the now following coating of the substrate the fixedly determined set of values of measured variables characteristic of the reactive discharge is held constant for each sub-target at least for a predetermined fraction of the duration of use of the sub-target by regulating the gas flow or the gas pressure by means of the regulated gas inlet and/or the supply duration of the pulsed power input,
d. the method steps a and b are repeated at predetermined intervals of time during the duration of use of the sub-targets, before the coating of the substrate is continued.

2. A method according to claim 1, characterized in that the set of values of the measured variables characteristic of the plasma discharge is formed from a triplet of values of discharge voltage, discharge current and power supplied to the plasma determined over the period.

3. A method according to claim 1, characterized in that the set of values of measured variables characteristic of the plasma discharge is formed by a pair of values of discharge voltage and an optically or electrically derived signal characterizing the plasma state.

4. A method according to claim 1, characterized in that the set of values of measured variables characteristic of the plasma discharge is formed by a pair of values of discharge power and an optically or electrically derived signal characterizing the plasma state.

5. A method according to claim 1, charactenzed in that the set of values of measured variables characteristic of the plasma discharge is formed by a pair of values of discharge current and an optically or electrically denved signal characterizing the plasma state.

6. A method according to claim 1 and any of claims 2 to 5, characterized in that the set of values of measured variables charactenstic of the plasma discharge is provided in dependence on the erosion state over the penod of use of the sub-targets.

7. A method according to claim 6, characterized in that the sets of values formed for the individual method steps are the same or different.

8. A method according to at least one of claims 1 to 7, characterized in that the penod is adjusted in the range from some microseconds to some seconds.

9. A method according to at least one of claims 1 to 8, characterized in that the power is so supplied that the sub-targets are always cathodes of the discharge during the supply time and the discharge strikes against at least one auxiliary electrode located in the discharge space and connected as anode.

10. A method according to at least one of claims 1 to 9, characterized in that the power is so supplied that, with a plurality of sub-targets, one part of the sub-targets is supplied in a period during the supply time as cathode and in each case at least one sub-target is connected as anode, in that during the following penod at least one sub-target previously connected as cathode is in each case connected as anode and vice versa, in that each sub-target has anode function with regular periodicity and in that the supply times and the powers supplied therein are chosen independently of one another for the two directions of polarisation.

11. A method according to claim 10, characterized in that at least one auxiliary electrode is connected as anode during the period.

12. A method according to claim 10, characterized in that at least one auxiliary electrode is adjusted to a freely selectable potential.

13. A method according to claim 9 to 12, charactenzed in that the power supply is so effected that the sub-targets are so connected with low resistance to the anode potential during the pause duration that the voltage between the sub-target and the anode of 15 V is not exceeded.

14. A method according to at least one of claims 1 to 13, characterized in that the set-point value of the power to be supplied used for the regulation is determined from real-time multiplication of discharge voltage and discharge current by average value formation over a period.

15. A method according to at least one of claims 1 to 14, characterized in that the reactive gas or reactive gas mixture is fed into the discharge space in the vicinity of the target or sub-target.

16. A method according to at least one of claims 1 to 15, characterized in that the discharge in the inert gas is struck without supply of reactive gas and the operating point of the discharge is then automatically set by means of a reactive gas regulating loop.

17. A method according to at least one of claims 1 to 15, charactenzed in that the reactive gas is struck in the inert gas/reactive gas mixture with a predetermined value of the reactive gas flow or reactive gases and the operating point of the discharge is then automatically set by means of a reactive gas regulating loop.

18. A method according to at least one of claims I to 17, characterized in that the power is supplied during the reactive coating according to a constant power technique and the reactive gas flow is so adjusted by means of the reactive gas regulating loop that the discharge voltage or the discharge current is stabilised at a predetermined value.

19. A method according to at least one of claims 1 to 17, characterized in that the power is supplied during the reactive coating according to a constant voltage technique and the reactive gas flow is so adjusted by means of the reactive gas regulating loop that the discharge power or the discharge current is stabilised at a predetermined value.

20. A method according to at least one of claims 1 to 17, charactenzed in that the power is supplied during the reactive coating according to a constant current technique and the reactive gas flow is so adjusted by means of the reactive gas regulating loop that the discharge voltage or the discharge power is stabilised at a predetermined value.

21. A method according to claim 1 to 17, characterized in that the reactive gas flow is held constant for one part of the sub-targets and the supply time of the pulsed power input of the predetermined set of values of measured variables characteristic of the reactive discharge is held constant for the other part of the sub-targets, by means of a plurality of regulating loops.

## Revendications

1. Procédé de revêtement réactif de substrats au moyen d'une source de pulvérisation selon le principe du magnétron, se composant d'une cible constituée d'au moins une partie, d'un système d'aimants derrière la cible et adapté à elle et d'au moins une entrée de gaz réglable, avec une alimentation en puissance pulsée dans le plasma pendant la durée d'une période, qui se compose d'une durée d'alimentation et d'une durée de pause,
caractérisé par les étapes suivantes :
a) avant le revêtement des substrats on modifie l'intensité du champ magnétique destiné à chaque cible partielle et/ou la durée d'alimentation de l'alimentation pulsée en puissance dans le gaz rare sans gaz réactif sous une pression de décharge jusqu'à ce que pour chaque cible partielle ou atteigne une série de valeurs prescrites de grandeurs mesurées caractéristiques de la décharge non réactive de plasma,
b) avant le revêtement des substrats on modifie les paramètres de décharge en maintenant constantes les valeurs établies de l'intensité de champ magnétique par l'entrée de gaz réactif ou d'un mélange de gaz réactif et de gaz rare et/ou de la durée d'alimentation de l'alimentation pulsée en puissance, jusqu'à ce qu'on atteigne pour chaque cible partielle une série de valeurs prescrites de grandeurs mesurées caractéristiques de la décharge réactive,
c) pendant le revêtement successif des substrats par réglage du débit de gaz ou de la pression de gaz au moyen de l'entrée de gaz réglable et/ou de la durée d'alimentation de l'alimentation pulsée en puissance, on maintient constante la série de valeurs prescrites, pour chaque cible partielle au moins pendant une fraction déterminée de la durée d'utilisation de la cible partielle, des grandeurs mesurées caractéristiques de la décharge réactive,
d) à des intervalles de temps définis pendant la durée d'utilisation de la cible partielle on répète les étapes de procédé a et b, avant de poursuivre le revêtement des substrats.

2. Procédé selon la revendication 1,
caractérisé en ce que
la série de valeurs des grandeurs mesurées caractéristiques de la décharge de plasma est constituée d'un triplet de valeurs de la tension de décharge, de l'intensité de décharge et de la puissance, injectée dans le plasma mesurée sur la durée de la période

3. Procédé selon la revendication 1,
caractérisé en ce que
la série de valeurs des grandeurs mesurées caractéristiques de la décharge de plasma est constituée d'une paire de valeurs de la tension de décharge et d'un signal caractéristique de l'état du plasma, obtenu optiquement ou électriquement.

4. Procédé selon la revendication 1,
caractérisé en ce que
la série de valeurs des grandeurs mesurées caractéristiques de la décharge de plasma est constituée d'une paire de valeurs de la puissance de décharge et d'un signal caractéristique de l'état du plasma obtenu optiquement ou électriquement.

5. Procédé selon la revendication 1,
caractérisé en ce que
la série de valeurs des grandeurs mesurées caractéristiques de la décharge de plasma est constituée d'une paire de valeurs de l'intensité de décharge et d'un signal caractéristique de l'état du plasma obtenu optiquement ou électriquement.

6. Procédé selon la revendication 1 et l'une des revendications 2 à 5,
caractérisé en ce que
la série de valeurs des grandeurs mesurées caractéristiques de la décharge de plasma est prescrite en fonction de l'état d'érosion pendant la durée d'utilisation de la cible partielle.

7. Procédé selon la revendication 6,
caractérisé en ce que
les séries de valeurs formées pour chaque étape de procédé sont identiques ou différentes.

8. Procédé selon au moins une des revendications 1 à 7,
caractérisé en ce qu'
on ajuste la durée de période dans l'intervalle de quelques microsecondes à quelques secondes.

9. Procédé selon au moins l'une des revendications 1 à 8,
caractérisé en ce qu'
on alimente la puissance de telle sorte que les cibles partielles pendant la durée d'alimentation, sont toujours des cathodes de la décharge et que la décharge brûle au contact d'au moins une électrode supplémentaire se trouvant dans la chambre de décharge, qui est branchée comme anode.

10. Procédé selon au moins l'une des revendications 1 à 9,
caractérisé en ce qu'
on alimente la puissance de telle façon que pour plusieurs cibles partielles dans une durée de période pendant la durée d'alimentation une partie des cibles partielles sont branchées comme cathode et au moins une partie des cibles partielles sont branchées comme anode, que dans la durée de période suivante pendant la durée d'alimentation on branche au moins une cible partielle jusqu'à maintenant comme cathode à l'anode et inversement que chaque cible partielle joue régulièrement périodiquement le rôle d'anode et qu'on choisit indépendamment l'une de l'autre pour les deux polarités les durées d'injection et les puissances qui y sont injectées.

11. Procédé selon la revendication 10,
caractérisé en ce qu'
on branche comme anode au moins une électrode supplémentaire pendant les durées de période.

12. Procédé selon la revendication 10,
caractérisé en ce qu'
on ajuste au moins une électrode supplémentaire pendant les durées de période à un potentiel électrique choisi librement.

13. Procédé selon les revendications 9 à 12,
caractérisé en ce que
l'alimentation en puissance a lieu, du fait que les cibles partielles pendant les durées de pause sont reliées par conduction ohmique peu résistante au potentiel d'anode et qu'ainsi la tension entre la cible partielle et l'anode ne dépasse pas 15 V.

14. Procédé selon au moins l'une des revendications 1 à 13,
caractérisé en ce que
la valeur de consigne utilisée pour le réglage de la puissance à injecter est déterminée par la multiplication exacte dans le temps de la tension de décharge et de l'intensité de décharge en réalisant une moyenne sur une durée de période.

15. Procédé selon au moins l'une des revendications 1 à 14,
caractérisé en ce qu'
on introduit le gaz réactif ou le mélange de gaz réactifs dans la chambre de décharge à proximité de la cible ou de la cible partielle.

16. Procédé selon au moins l'une des revendications 1 à 15,
caractérisé en ce qu'
on amorce la décharge dans le gaz rare sans introduction de gaz réactif et qu'ensuite on ajuste automatiquement le point de travail de la décharge au moyen d'une vanne de régulation de gaz réactif.

17. Procédé selon au moins l'une des revendications 1 à 15,
caractérisé en ce qu'
on amorce la décharge réactive dans le mélange gaz rare-gaz réactif avec une valeur prescrite du débit de gaz réactif ou du gaz réactif et qu'ensuite on ajuste automatiquement le point de travail de la décharge au moyen d'une vanne de régulation de gaz réactif.

18. Procédé selon au moins l'une des revendications 1 à 17,
caractérisé en ce qu'
on alimente la puissance pendant le revêtement réactif selon un mode de procédé à puissance constante et qu'on ajuste le débit de gaz réactif au moyen de la vanne de régulation de gaz réactif, de telle sorte qu'on stabilise la tension de décharge ou l'intensité de décharge à une valeur prescrite.

19. Procédé selon au moins l'une des revendications 1 à 17,
caractérisé en ce qu'
on alimente la puissance pendant le revêtement réactif, selon un mode de procédé à tension constante et qu'on ajuste le débit de gaz réactif au moyen de la vanne de régulation de gaz réactif, de telle sorte qu'on stabilise la puissance de décharge ou l'intensité de décharge à une valeur prescrite.

20. Procédé selon au moins l'une des revendications 1 à 17,
caractérisé en ce qu'
on alimente la puissance pendant le revêtement réactif, selon un mode de procédé à intensité constante et qu'on ajuste le débit de gaz réactif au moyen de la vanne de régulation de gaz réactif, de telle sorte qu'on stabilise la tension de décharge à une valeur prescrite.

21. Procédé selon au moins l'une des revendications 1 à 17,
caractérisé en ce qu'
on maintient constant le débit de gaz réactif par plusieurs vannes de régulation pour une partie des cibles partielles et pour l'autre partie des cibles partielles on maintient constante la durée d'alimentation de l'alimentation en puissance pulsée de la série de valeurs prescrites pour chaque cible partielle des grandeurs mesurées caractéristiques de la décharge réactive.
